# EUROPÄISCHE PATENTSCHRIFT

(11) **EP 0 327 082 B1**
(45) Veröffentlichungstag und Bekanntmachung des Hinweises auf die Patenterteilung: **06.10.1993**
(21) Anmeldenummer: 89101774.1
(22) Anmeldetag: 02.02.1989
(51) Int. Cl.: H03K 17/97, H03K 17/972

(54) **Elektrischer Schalter**
Electrical switch
Commutateur électrique

(30) Priorität: 04.02.1988 DE 3803284
(43) Veröffentlichungstag der Anmeldung: 09.08.1989
(73) Patentinhaber: DIEHL GMBH & CO., 90478 Nürnberg (DE)
(72) Erfinder: Krummer, Thomas, D-8832 Weissenburg (DE)

(56) Entgegenhaltungen:
- FR-A- 2 180 203
- IBM TECHNICAL DISCLOSURE BULLETIN, Band 24, Nr. 10, März 1982, Seiten 5271-5272, New York, US; V. BERTIS: "Key with electrical tactile feedback"

## Beschreibung

Die Erfindung betrifft einen elektrischen Schalter mit einem Druckknopf, der gegen die Wirkung einer Feder betätigbar ist.

Elektrische Schalter der vorgenannten Art sind allgemein bekannt. So offenbart die DE-AS 19 39 642 einen auf liniarem Druck basierenden Schalter für ein prellfreies Schalten mit einem Druckknopf, welcher axial gegen die Wirkung von eingesetzten Federn betätigbar ist.

Ein anderer Schalter ist durch die DE-OS 23 35 907 bekannt, bei dem wiederum eine Taste zur Erzeugung elektrischer Signale axial gegen die Wirkung von Federn bewegbar ist. Sobald der Druck auf die Taste bzw. den Druckknopf bei diesen Schaltern aufgehoben wird, springt der Druckknopf aufgrund der einwirkenden Federkräfte in die Ausgangslage zurück. Gleichzeitig wird dadurch der elektrische Kontakt zwischen den festen Kontaktstiften gelöst.

Diese geschilderten Schalter sind durchwegs mechanisch kontaktierende Schalter, die nur für bestimmte Anwendungsfälle einsetzbar sind, bei denen relativ geringe Schaltspiele gefordert werden.

Die FR-A 2 180 203 beschreibt einen elektrischen Schalter mit einem Druckknopf, der gegen die Wirkung einer Feder betätigbar ist. Bei diesem bekannten Schalter ist in axialer Verlängerung des Druckknopfes im Schaltergehäuse ein Permanentmagnet vorgesehen, der in axialen Abstand einer Hallsonde gegenübersteht. Dieser bekannte Schalter weist jedoch den Nachteil auf, daß seine Funktionsfähigkeit während des Betriebs nicht elektronisch überprüft werden kann.

Für besondere Anwendungsfälle, bspw. für Bediengriffe zur Führung von Luftfahrzeugen, werden jedoch Schalter benötigt, die eine nahezu unbegrenzte Menge von Schaltzyklen zulassen und dabei eine große Funktionssicherheit aufweisen.

Aufgabe der Erfindung ist es deshalb, einen elektrischen Schalter der eingangs genannten Art zu schaffen, der kontaktlos arbeitet und zuverlässig eine nahezu unbegrenzte Menge von Schaltzyklen gewährleistet und kontinuierlich über eine Auswerteelektronik testbar ist.

Erfindungsgemäß wird diese Aufgabe mit den Merkmalen des Anspruchs 1 gelöst. Dabei kann sich in Ausbildung der Erfindung an den aus dem Gehäuse vorstehenden Druckknopf ein Schaltstößel axial anschließen, an dessen Ende im Gehäuseinneren der Permanentmagnet vorgesehen ist, der bei unbetätigtem Schalterzustand im axialen Abstand zur zugewandten Stirnfläche der Spule angeordnet ist und bei niedergedrücktem Druckknopf mit axial nur geringem Spalt vor dem Spulenkern angeordnet ist.

Der Druckknopf kann bei diesem erfindungsgemäßen Schalter einen innenliegenden Bund aufweisen, der mit einer radialen Sackbohrung versehen ist, in die eine federunterstützte Rastkugel eingesetzt ist, die an der Innenmantelfläche der Gehäuseausnehmung anliegt und bei niedergedrücktem Druckknopf nach Überwinden eines Gehäusevorsprunges in einer Ringnut der Gehäuseausnehmung liegt. Die Überwindung des Vorsprunges der Gehäusewand führt vorteilhafterweise zur Erzeugung eines notwendigen Schaltdruckpunktes. Nach dieser Druckpunkterhöhung fällt die Kugel anschließend bei weiterem Axialdruck in die Ringnut ein, was sofort zu einer fühlbaren Druckwiderstandsreduzierung führt.

Die Dimensionierung der Spule kann gemäß der Erfindung der Forderung unterliegen, daß ihr Magnetfluß wesentlich größer ist als der Magnetfluß des Permanentmagneten.
Der Hallsensor kann eine integrierte Auswerteelektronik aufweisen, welche aus den hintereinander geschalteten Bauelementen Hallelement, linearer Verstärker, Schmitt-Trigger und Schalttransistor gebildet ist, denen ein Spannungsregler zugeordnet ist.

Das Schaltgehäuse ist in bevorzugter Ausführung zumindest im Bereich des Hallsensors mit Spule und Permanentmagnet aus einem ferromagnetischen Material gebilded.
Einer oder mehrere dieser elektrischen Schalter sind als testbarer Sensor-Druckknopfschalter mit einer Auswerteeinheit zum Zweck der Funktionsprüfung im ungeschalteten wie im geschalteten Zustand verbindbar. Ferner können im Falle einer notwendigen seriellen Datenübertragung mehrere Sensorschalter in einer Matrix verschaltbar sein.

Ein solcher elektrischer Schalter besitzt zunächst einmal eine vorteilhafte Stellcharakteristik, was vor allem für diese kontaktlosen Schalter bei ihrem Einsatz in Luftfahrtgeräte sinnvoll ist.
Durch diese Stellcharakteristik kann der Druckpunkt fühlbar gemacht werden und es wird ein ungewolltes Auslösen durch zufälliges Berühren vermieden. Gleichzeitig wird aber auch die Rückführung der Stellteile in die Null-Lage gewährleistet.
Ein weiterer besonderer Vorteil dieser elektrischen Schalter ist die Kombination der kontaktlosen Schaltelemente mit der Stellcharakteristik und der Stellkräfte von Schaltern mechanischer Bauart. Durch den Einsatz eines Hallsensors mit einer integrierten Auswerteelektronik ist eine nahezu unbegrenzte Anzahl von Schaltspielen möglich, wobei die Schaltrichtung erkannt wird. Es sind extrem langsame Schaltvorgänge und ebenso auch hochfrequente Schaltspiele erfaßbar. Die geforderte Testbarkeit dieses elektrischen Schalters ist durch die Spule gewährleistet. Dadurch ist eine Funktionsprüfung des Sensors im nicht geschalteten Zustand auf mögliches Leerlaufverhalten ebenso durchführbar wie im geschalteten Zustand durch den negativen Spulstrom ein Kurzschlußverhalten des Sensors erfaßbar ist. Der elektrische Schalter und die Signalleitungen werden mit begrenztem Aufwand kontinuierlich testbar. Eine Signalfreigabe erfolgt immer erst nach bestandener Funktionsprüfung.

Der elektrische Schalter besteht also insgesamt aus den drei Baueinheiten: Funktionsteil-Stellcharakteristik, Funktionsteil-Anregung und Anschluß.

Durch die Dimensionierung der Spule dergestalt, daß der Magnetfluß der Spule wesentlich größer ist als der Magnetfluß des Permanentmagneten, wirkt das Magnetfeld der Spule dem des Permanentmagneten im eingeschalteten Zustand des Schalters entgegen und reaktiviert kurzzeitig den Hallsensor.
Erst nach mehrfach bestandenem Funktionstest innerhalb weniger als 0,5 Millisekunden wird von der Auswerteelektronik das eigentliche Schaltsignal erzeugt. Dadurch, daß alle zur Sensierung notwendigen Komponenten in einem ferromagnetischen Gehäuse aus einem MU-Metall gekapselt sind, werden kleine und mittlere Streufelder gut abgeschirmt. Ferner wird zur Erhaltung der Funktion des Sensors bei einer Stimulation mit dem Permanentmagneten der magnetische Fluß über das Schaltergehäuse geschlossen.

Weitere Einzelheiten und vorteilhafte Angaben werden in der nachfolgenden Zeichnungsbeschreibung gemacht, die sich auf die in den Figuren wiedergegebenen Beispiele bezieht.
Es zeigen:
- Fig. 1: den elektrischen Schalter im Schnitt;
- Fig. 2: ein Blockschaltbild der in dem Hallsensor integrierten Elektronik;
- Fig. 3: der elektrische Schalter gemäß Fig. 1 im eingeschalteten Zustand mit Stimulierung des Sensors;
- Fig. 4: der elektrische Schalter gemäß Fig. 1 im Schnitt mit Stimulierung des Sensors und dem Testen des Sensors durch die Spule;
- Fig. 5: ein Zeitdiagramm für den Schaltertest.

Der elektrische Schalter 1 besteht im wesentlichen aus den drei Einheiten
- Funktionsteil-Stellcharakteristik
- Funktionsteil-Anregung
- Anschluß.

Alle wesentlichen Bauteile sind in einem Schaltergehäuse 2 aus einem ferromagnetischen Material untergebracht. Auf der Bedienseite ragt ein Druckknopf 3 aus einem Deckel 4 des Gehäuses 2 hervor. Der Druckknopf 3 steht dabei mit einem Bund 5 an einer Schulter der Deckelausnehmung 6 an. In axialer Verlängerung des Druckknopfes 3 ist ein breiter Bund 7 vorgesehen, der eine radiale Sackbohrung 8 aufweist, in die eine Kugel 9 mit einer Druckfeder 10 eingeführt ist. Ein Schaltstößel 11 ragt in axialer Verlängerung des Druckknopfes 3 durch die abgestufte Ausnehmung 12 des Schaltergehäuses 2 und besitzt an seinem axialen Ende eine Scheibe 13. Um den Schaltstößel 11 befindet sich eine Druckfeder 14, die als Rückstellfeder für den Druckknopf 3 dient und sich einerseits am Bund 7 und andererseits an einer axialen Gehäusewandung in der Ausnehmung 12 abstützt. Die Ausnehmung 12 des Schaltergehäuses 2 weist im oberen Bereich eine umlaufende Ringnut 15 auf, die zur Stirnseite des Schaltergehäuses 2 konisch ausläuft.

Das Funktionsteil der Stellcharakteristik besteht aus dem Druckknopf 3 mit dem Bund 7, dem Schaltstößel 11, der Druckfeder 14 und der federunterstützten Kugel 9 innerhalb des oberen Teils des Schaltergehäuses 2.

An der Scheibe 13 befindet sich in axialer Ausdehnung der Permanentmagnet 16 mit seiner Nordpolung 16.1 und Südpolung 16.2. Im axialen Abstand zu der Nordpolung 16.1 des Permanentmagneten 16 ist im ungeschalteten Zustand des elektrischen Schalters 1 eine Spule 17 um den Spulenkern 18 angeordnet. Die Spule 17 liegt axial an dem Hallsensor 19 an, der seinerseits mit den Anschlußstiften 20 elektrisch verbunden ist. Die Anschlußstifte 20 ragen aus Öffnungen des Bodens 21 des Schaltergehäuses hervor. Die Spule 17 und der Hallsensor sind über fünf elektrische Leitungen 22 mit einer Auswerteeinheit 24 verbindbar.

Das Funktionsteil "Anregung" besteht gemäß dem konstruktiven Aufbau des elektrischen Schalters 1 aus der Scheibe 13, dem Permanentmagneten 16, der Spule 17 und dem Hallsensor 19.

Das Funktionsteil "Anschluß" schließlich wird aus den Anschlußstiften 20 des elektrischen Schalters 1 gebildet.

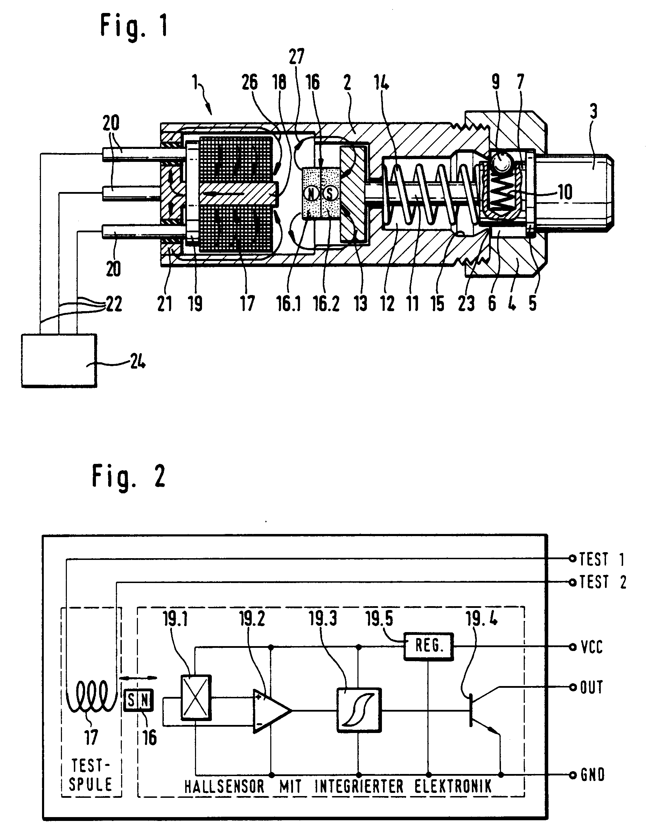

Wie aus dem Blockschaltbild der Fig. 2 erkenntlich ist, besitzt der Hallsensor 19 eine integrierte Elektronik, die aus einem Hallelement 19.1, einem Linearverstärker 19.2, einem Schmitt-Trigger 19.3 und einem Transistorschalter 19.4 besteht, die alle hintereinander geschaltet sind. Ein eingesetzter Spannungsregler 19.5 sorgt für ein fortlaufend gleiches Spannungsniveau.

Mittels der dargestellten Konfiguration des elektrischen Schalters in Fig. 1 kann dieser durch die eingesetzte Spule 17 auf ordnungsgemäße Funktion in jeder Betriebsstellung, nämlich im eingeschalteten und im ausgeschalteten Zustand, getestet werden. Dabei richtet sich die Funktionsprüfung des Hallsensors 19 im nicht geschalteten Zustand des Druckschalters 1 bei einem positiven Spulenstrom auf ein mögliches Leerlaufverhalten des Hallsensors 19. Im geschalteten Zustand dagegen wird durch den dann negativen Spulenstrom die Freigabe eines Signals bei einem evtl. Kurzschlußverhalten des Hallsensors 19 verhindert. Der elektrische Schalter und die Signalleitungen sind mit einem begrenzten Aufwand kontinuierlich testbar. Eine Signalfreigabe bei eingeschaltetem Schalter 1 erfolgt erst nach der bestandenen Funktionsprüfung.

Die Dimensionierung der Spule 17 erfolgt unter der Forderung, daß der Magnetfluß der Spule 17 wesentlich größer ist als der Magnetfluß des Permanentmagneten 16. Im eingeschalteten Zustand des elektrischen Schalters 1 wirkt das Magnetfeld der Spule 17 dem Magnetfeld des Permanentmagneten 16 entgegen und reaktiviert kurzzeitig den Hallsensor 19. Erst nach einem mehrfach bestandenen Funktionstest wird von der Auswerteelektronik extern das eigentliche Schaltsignal erzeugt.
Das Gegenfeld der Spule 17 führt durch seine geeignete Dimensionierung nicht zu einer Entmagnetisierung des Permanentmagneten 16.

Alle zur Sensierung notwendigen Komponenten des elektrischen Schalters 1 sind in einem ferromagnetischen Gehäuse 2, z.B. aus einem MU-Metall, gekapselt. Kleine und mittlere Streufelder werden durch dieses besondere Material abgeschirmt. Außerdem werden eine hohe Permeabilität und eine niedrige Koezitivfeldstärke durch dieses Material bereitgestellt, damit bei Stimulation mit dem Permanentmagneten 16 der magnetische Fluß über das Gehäuse 2 geschlossen werden kann.

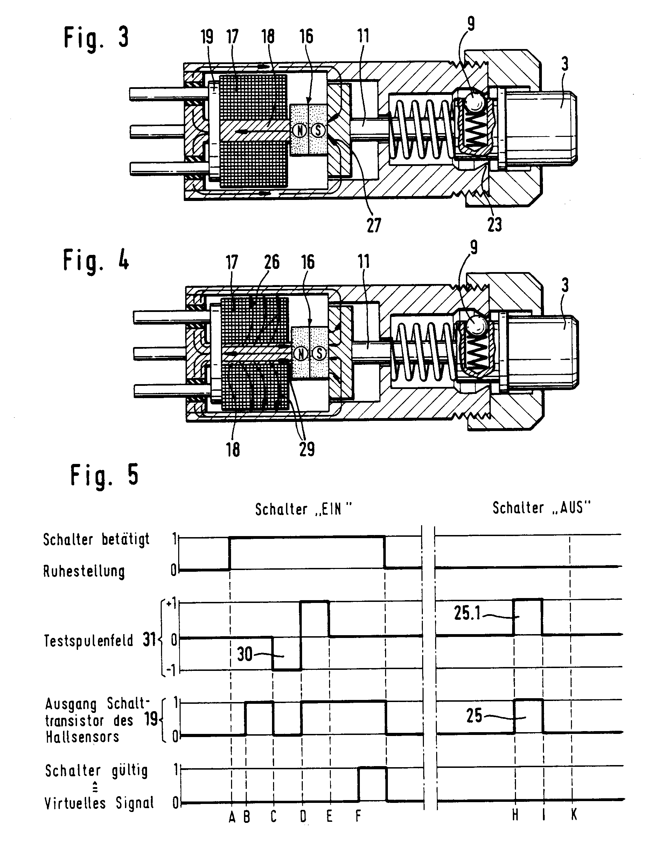

Die Testphase des elektrischen Schalters 1 im ausgeschalteten Zustand nach Fig. 1 erfolgt dadurch, daß eine an die Spule 17 angeschlossene Auswerteeinheit 24 zuerst die Datenleitung und den Hallsensor 19 zum Zeitpunkt H gemäß Fig. 5 prüft und dabei kurzzeitig die Spule mit einem positiven Konstantstrom versorgt. Dieser Strom baut nun durch die Spule 17 im elektrischen Schalter 1 ein Magnetfeld auf, welches den Schalttransistor 19.4 im Hallsensor 19 anregt. Bei ordnungsgemäßer Funktion des Hallsensors 19 wird die Datenleitung auf "logisch 1" geschaltet. Wie aus dem Testspulenfeld in Fig. 5 zu dem Zustand des ausgeschalteten Schalters 1 erkenntlich ist, erfolgt dadurch ein kurzer Sprung in Form eines Rechteck-Signals 25, welches von der Auswerteeinheit 24 abgefragt wird, die nach einer kurzen Beruhigungsphase die Datenleitung auf den Zustand "logisch 0" zum Zeitpunkt K in Fig. 5. prüft. Bei einem Leerlaufverhalten des Hallsensors 19 oder einer Unterbrechung der Datenleitung wird diese Testphase insgesamt nicht korrekt durchlaufen. Dieser fehlerhafte Durchlauf wird von der Auswerteeinheit 24 als Fehler erkannt und der Bedienungsperson mitgeteilt.

Bei dem ausgeschalteten Zustand des elektrischen Schalters 1 ist also ein Spulenstrom mit positivem Rechteck-Signal 25 vorhanden, welches bei einem Fehler im Leerlaufverhalten auf 0 egalisiert wird. Während dieser geschilderten Testphase des elektrischen Schalters 1 baut die Spule 17 ein Magnetfeld auf, welches durch die Pfeile 26 in Fig. 1 dargestellt ist. Das Magnetfeld des Permanentmagneten wird durch die Pfeile 27 erläutert.

Die Funktionsbeschreibung des Schaltertestes für den elektrischen Schalter 1 im eingeschalteten Zustand wird anhand der Figuren 3 und 4 nachfolgend erläutert.
Wie aus diesen Figuren 3 und 4 zu erkennen ist, ist der Druckknopf 3 jeweils eingedrückt worden, wobei die Kugel 9 nach deutlich fühlbarem Überfahren der Kante 23 in der Ringnut 15 der Ausnehmung 12 des Schaltergehäuses 2 liegt. Der Permanentmagnet 16 ist durch den Schaltstößel 11 an die zugewandte Stirnfläche des Spulenkerns 18 verschoben worden, ohne an dem Spulenkern 18 zur Anlage zu kommen. Zwischen dem Spulenkern 18 und dem Permanentmagneten 16 bildet sich in diesem Schalterzustand ein relativ kleiner Spalt.

In Fig. 3 ist nun zunächst nur die Stimulierung des Hallsensors 19 durch den Permanentmagneten 16 dargestellt. Die hierbei fließenden Ströme sind durch die Pfeile 28 verdeutlicht.

In Fig. 4 ist dagegen zusätzlich zu der Stimmulierung des Hallsensors 19 durch den Permanentmagneten 16 auch dargestellt worden, daß die Spule 17 den Hallsensor 19 testet. Die bei diesem Vorgang insgesamt fließenden Ströme und sich aufbauenden Magnetfelder sind durch die Pfeile 29 dargestellt.

Die Funktionsbeschreibung erfolgt nun auch unter der Betrachtung der Fig. 5 für den Zustand des eingeschalteten Schalters 1. Bei der Betätigung des elektrischen Schalters 1 über den Druckknopf 3 wird der Ausgang des Hallsensors 19 zum Zeitpunkt A in Fig. 5 aktiviert und der Schalttransistor zum Zeitpunkt B durchgeschaltet. Die eigentliche Testphase wird zum Zeitpunkt C in Fig. 5 eingeleitet. Die Auswerteeinheit 24 steuert die Spule 17 an, und dem negative Konstantstrom gemäß dem Rechtecksignal 30 im Testspulenfeld 31 erzeugt durch die Spule 17 im elektrischen Schalter 1 ein Magnetfeld, welches dem Magnetfeld des Permanentmagneten 16 entgegengesetzt gerichtet ist. Das resultierende Gesamtmagnetfeld wird gleich oder kleiner Null und führt dazu, daß der Schalttransistor 19.4 des Hallsensors 19 sperrt.

Im Fehlerfall des elektrischen Schalters 1 wird die Datenleitung diesen High-Pegel beibehalten. Das Fehlen eines Sprunges wird von der Auswerteeinheit 24 erkannt und als Fehler berücksichtigt. Ein solcher Fehler kann bspw. eine Unterbrechung der Spulenleitung oder aber ein Transistor- Collector-Emitter-Schluss bzw. Kurzschluß der Datenleitung bedeuten.

Wird nun in dieser Testphase anschließend die Testspulengruppe umgepolt, so wird zum Zeitpunkt D in Fig. 5 der magnetische Fluß des Permanentmagneten 16 schnell wieder aufgebaut. Der Schalttransistor 19.4 schaltet durch, und die Datenleitung wird damit auf den Zustand "logisch 1" geschaltet. Anschließend schaltet auch die Auswerteeinheit 24 die Spule 17 stromlos.

Nur wenn der gesamte Testzyklus ordnungsgemäß durchlaufen wurde, erkennt die Auswerteeinheit 24 das Schaltersignal als gültig zum Zeitpunkt F in Fig. 5 an. Das virtuelle Signal für den gültigen Schalter wird von der Auswerteeinheit 24 erzeugt.

Das negative Signal 30 im Testspulenfeld 31 steht für den Test auf das Kurzschlußverhalten, während das positive Rechtecksignal 25.1 den Testlauf auf das Verlaufverhalten bedeutet.

## Patentansprüche

1. Elektrischer Schalter mit einem Druckknopf (3), der gegen die Wirkung einer Feder (14) betätigbar ist, wobei
in axialer Verlängerung des Druckknopfes (3) im Schaltergehäuse (2) ein Permanentmagnet (16) vorgesehen ist, der einer Spule (17) gegenübersteht, die mit ihrer abgewandten Stirnseite an einem mit den Anschlußstiften (20) in Verbindung stehenden Hallsensor (19) anliegt.

2. Elektrischer Schalter nach Anspruch 1,
dadurch gekennzeichnet,
daß sich an den aus dem Gehäuse (2) vorstehenden Druckknopf (3) ein Schaltstößel (11) axial anschließt, an dessen Ende im Gehäuseinnern der Permanentmagnet (16) vorgesehen ist, der bei unbetätigtem Schalterzustand im axialen Abstand zur zugewandten Stirnfläche der Spule (17) angeordnet ist und bei niedergedrücktem Druckknopf (3) in axial geringem Abstand zum Spulenkern (18) angeordnet ist.

3. Elektrischer Schalter nach den Ansprüchen 1 und 2,
dadurch gekennzeichnet,
daß der Druckknopf (3) einen innenliegenden Bund (7) aufweist, der mit einer radialen Sackbohrung (8) versehen ist, in die eine federunterstützte Rastkugel (9) eingesetzt ist, die an der Innenmantelfläche der Gehäuseausnehmung (12) anliegt und bei niedergedrücktem Druckknopf (3) nach Überwinden des Vorsprunges (23) an der Gehäuseinnenwand in eine Ringnut (15) der Gehäuseausnehmung (12) einrastet.

4. Elektrischer Schalter nach den Ansprüchen 1 und 2,
dadurch gekennzeichnet,
daß die Dimensionierung der Spule (17) der Forderung unterliegt, daß ihr Magnetfluß wesentlich größer ist als der Magnetfluß des Permanentmagneten (16).

5. Elektrischer Schalter nach den Ansprüchen 1 und 2,
dadurch gekennzeichnet,
daß der Hallsensor (19) eine integrierte Elektronik (19.1-19.5) aufweist, welche aus den hintereinander gestalteten Bauelementen Hallelement (19.1), linearer Verstärker (19.2), Schmitt-Trigger (19.3) und Schalttransistor (19.4) gebildet ist, denen ein Spannungsregler (19.5) zugeordnet ist.

6. Elektrischer Schalter nach den Ansprüchen 1 bis 5,
dadurch gekennzeichnet,
daß das Schaltergehäuse (2) zumindest im Bereich des Hallsensors (19) mit Spule (17) und Permanentmagneten (16) aus einem ferromagnetischen Material gebildet ist.

7. Elektrischer Schalter nach den Ansprüchen 1 bis 6,
dadurch gekennzeichnet,
daß er als testbarer Sensor-Druckknopfschalter mit einer Auswerteeinheit (24) zum Zweck der Funktionsprüfung im ungeschalteten wie im geschalteten Zustand verbindbar ist.

8. Elektrischer Schalter nach den Ansprüchen 1 bis 7,
dadurch gekennzeichnet,
daß im Falle einer notwendigen seriellen Datenübertragung mehrere testbare Sensorschalter (1) zu einer Matrix verschaltbar sind.

## Claims

1. An electrical switch having a push-button (3) which is actuable against the action of a spring (14), in which respect provided in axial extension of the push-button (3) in the switch housing (2) is a permanent magnet (16) which stands opposite a coil (17), which butts with its remote front side against a Hall sensor (19) communicating with the connection pins (20).

2. An electrical switch according to Claim 1, characterised in that linking axially on to the push-button (3) protruding from the housing (2) is a switching plunger (11), at the end of which in the interior of the housing the permanent magnet (16) is provided, which in the unactuated switch state is arranged at an axial spacing from the facing front surface of the coil (17) and with the push-button (3) depressed is arranged at an axially slight spacing from the coil core (18).

3. An electrical switch according to Claims 1 and 2, characterised in that the push-button (3) has an inwardly lying collar (7), which is provided with a radial blind-hole bore (8), into which a spring-assisted detent ball (9) is inserted, which butts against the inner surface of the housing recess (12) and with the push-button (3) depressed after overcoming the projection (23) on the inner wall of the housing engages into an annular groove (15) of the housing recess (12).

4. An electrical switch according to Claims 1 and 2, characterised in that the dimensioning of the coil (17) is subject to the requirement that its magnetic flux is considerably greater than the magnetic flux of the permanent magnet (16).

5. An electrical switch according to Claims 1 and 2, characterised in that the Hall sensor (19) has integrated electronics (19.1-19.5) formed from the series-connected component parts of Hall element (19.1), linear amplifier (19.2), Schmitt trigger (19.3) and switching transistor (19.4), with which a voltage regulator (19.5) is associated.

6. An electrical switch according to Claims 1 to 5, characterised in that the switch housing (2) is formed at least in the region of the Hall sensor (19) with coil (17) and permanent magnet (16) from a ferromagnetic material.

7. An electrical switch according to Claims 1 to 6, characterised in that it is connectable as a testable sensor push-button switch to an evaluation unit (24) for the purpose of the operational test in the unswitched as in the switched state.

8. An electrical switch according to Claims 1 to 7, characterised in that in the case of a necessary serial data transmission several testable sensor switches (1) can be wired up to form a matrix.

## Revendications

1. Interrupteur électrique, avec un bouton-poussoir (3), pouvant être actionné à l,encontre de l'action d'un ressort (14), un aimant permanent (16) étant prévu dans le prolongement axial du bouton-poussoir (3), dans le boîtier d'interrupteur (2), en regard d'une bobine (17), appliquée par sa face frontale opposée sur un capteur à effet Hall (19) relié aux broches de raccordement (20).

2. Interrupteur électrique selon la revendication 1, caractérisé en ce qu'au bouton-poussoir (3) faisant saillie hors du boîtier (2) se raccorde axialement un poussoir de commutation (11), à l'extrémité duquel est prévu, à l'intérieur du boîtier, l'aimant permanent (16) qui, à l'état non actionné du commutateur, est disposé à distance axiale par rapport à la face frontale, tournée vers lui, de la bobine (17) et, lorsque le bouton-poussoir (3) est enfoncé, est disposé à faible distance axiale par rapport au noyau de bobine (18).

3. Interrupteur électrique selon les revendications 1 et 2, caractérisé en ce que le bouton poussoir (3) présente une collerette intérieure (7), pourvue d'un trou borgne radial (8), dans lequel est insérée une bille servant de cliquet (9), assistée par un ressort et appuyant sur la surface d'enveloppe intérieure de l'évidement de boîtier (12) et s'encliquetant, lorsque le bouton poussoir (3) est enfoncé, dans une gorge annulaire (15) de l'évidement de boîtier (12), après avoir surmonté la saillie (23) réalisée sur la paroi intérieure de boîtier.

4. Interrupteur électrique selon les revendications 1 et 2, caractérisé en ce que le dimensionnement de la bobine doit remplir la condition de supériorité de son champ magnétique par rapport à celui de l'aimant permanent (16).

5. Interrupteur électrique selon les revendications 1 et 2, caractérisé en ce que le capteur à effet Hall (19) présente une électronique intégrée (19.1 à 19.5), formée des composants placées les uns derrière les autres que sont un élément à effet Hall (19;1), un amplificateur linéaire (19.2), une bascule de Schmidt (19.3) et un transistor de commutation (19;4), auxquels est associé un régulateur de tension (19.5).

6. Interrupteur électrique selon les revendications 1 à 5, caractérisé en ce que le boîtier d'interrupteur (2) est formé en un matériau ferromagnétique, au moins dans la zone du capteur à effet Hall (19), avec la bobine (17) et l'aimant permanent (16).

7. Interrupteur électrique selon les revendications 1 à 6, caractérisé en ce qu'il peut être relié, à titre d'interrupteur à bouton-poussoir à fonction de capteur, pouvant être testé, avec une unité d'exploitation (24), en vue de contrôler le fonctionnement tant à l'état non commuté qu'à l'état commuté.

8. Interrupteur électrique selon les revendications 1 à 7, caractérisé en ce que plusieurs interrupteurs capteurs (1) testables peuvent être mis en circuit en formant une matrice, en cas de nécessité d'une transmission série de données.
